**Europäisches Patentamt**

**European Patent Office**

**Office européen des brevets**

(11) Veröffentlichungsnummer: **0 119 462**
**A2**

# (12) EUROPÄISCHE PATENTANMELDUNG

(21) Anmeldenummer: **84101497.0**

(22) Anmeldetag: **14.02.84**

(51) Int. Cl.³: **H 03 B 5/32**

(30) Priorität: **17.02.83 DE 3305453**

(43) Veröffentlichungstag der Anmeldung: **26.09.84**
**Patentblatt 84/39**

(84) Benannte Vertragsstaaten: **AT BE CH DE FR GB IT LI NL**

(71) Anmelder: **Siemens Aktiengesellschaft, Berlin und München Wittelsbacherplatz 2, D-8000 München 2 (DE)**

(72) Erfinder: **Fütterer, Augustin, Ing.grad., Sonnenweg 6, D-8057 Eching/Dietersheim (DE)**

(54) **Spannungsgesteuerter Oszillator.**

(57) Spannungsgesteuerte Oszillatoren mit Schwingfrequenzen von über 100 MHz werden häufig in Phasenregelschaltungen eingesetzt, so daß sich neben einem relativ großen Ziehbereich auch die Forderung nach möglichst linearem Zusammenhang zwischen Steuerspannung und Frequenzänderung bei sehr geringer Dämpfungsänderung ergibt.

Nach der Erfindung wird ein spannungsgesteuerter Oszillator vorgeschlagen, der einen aus zwei emittergekoppelten Differenzverstärkerstufen bestehenden Verstärker enthält, in dessen Rückkopplungsnetzwerk die Reihenschaltung eines 3dB-0°-Kopplers mit zusätzlichem Steuerteil und einer Oberflächenwellenleitung enthält. Der erfindungsgemäße Oszillator ist insbesondere bei der Übertragung digitaler Signale mit Übertragungsgeschwindigkeiten von über 100 Mbit/s einsetzbar.

SIEMENS AKTIENGESELLSCHAFT
Berlin und München

VPA   83 P 1082 E

## Spannungsgesteuerter Oszillator für höhere Frequenzen

Die Erfindung betrifft einen spannungsgesteuerten Oszillator mit einem Verstärker und einem steuerbare
Kapazitätsdioden enthaltenden Rückkopplungsnetzwerk.

Spannungsgesteuerte Oszillatoren der eingangs erwähnten
Art werden häufig in der digitalen Übertragungstechnik
in Übertragungsstrecken und Multiplexgeräten mit Übertragungsgeschwindigkeiten von über 100 Mbit/s verwendet.
In den Regeneratoren und den Frequenzumsetzern in Leitungsendgeräten werden derartige hochstabile Oszillatoren
benötigt, die über einen relativ großen Bereich von beispielsweise $\pm 5 \cdot 10^{-4}$ ziehbar sind. Dabei muß ein möglichst
linearer Zusammenhang zwischen Steuerspannung und
Frequenzänderung vorhanden sein, damit sich bei Einsatz
der Oszillatoren in Phasenregelschaltungen keine
nichtlinearen Eigenschaften wie z.B. Güteänderungen
ergeben. Wegen der Verwendung in ferngespeisten Regeneratoren soll die Stromaufnahme möglichst gering sein,
im Hinblick auf die üblicherweise verwendete Schaltungstechnik in derartigen Frequenzbereichen wird ein ECLkompatibler Ausgang gefordert. Die genannten Forderungen
sind mit Quarzoszillatoren nach dem Stande der Technik
schwer zu erfüllen, da Obertonquarze im Frequenzbereich oberhalb 100 MHz schwer ziehbar sind und deshalb
dort nur Grundton-Quarzoszillatoren mit nachgeschalteten
Vervielfacherstufen eingesetzt werden können. Durch die
Vervielfacherstufen steigt in Verbindung mit der weiteren
Umformung des Oszillatorausgangssignals und der Selektion
der gewünschten Oberwelle der Aufwand stark an. Auch die
Anwendung von LC-Oszillatoren in dem genannten Frequenzbereich und in Verbindung mit den eingangs genannten

16.2.83/Ah   1 Seu

Forderungen führt zu einem großen Aufwand, da wegen der Instabilität dieser Oszillatoren unter dem Einfluß von Alterung und schwankender Temperatur zusätzliche Stabilisierungsmaßnahmen erforderlich sind.

Der Erfindung liegt also die Aufgabe zugrunde, einen spannungegesteuerten Oszillator der eingangs erwähnten Art zu schaffen, der die eingangs erwähnten Forderungen bei vergleichsweise geringem Aufwand erfüllt.

Erfindungsgemäß wird die Aufgabe dadurch gelöst, daß das Rückkopplungsnetzwerk die Reihenschaltung einer Oberflächenwellenleitung mit einem Durchlaßbereich entsprechend der vorgesehenen Oszillatorfrequenz und eines 3dB-90° Kopplers mit zusätzlichem Steuerteil enthält und daß die beiden steuerbaren Kapazitätsdioden über Koppelkondensatoren mit denjenigen beiden Anschlüssen des 3dB-90°-Kopplers verbunden sind, die nicht als Eingangs- oder Ausgangsanschluß dienen.

Die erfindungsgemäße Lösung bietet in vorteilhafter Weise die Möglichkeit, ohne zusätzliche Umformungsstufen und Selektionsmittel ein rechteckförmiges Ausgangssignal im gewünschten Frequenzbereich zu erzeugen. Als weiterer Vorteil ergibt sich, daß der Grad der Rückkopplung im Oszillator unabhängig von der Schwingfrequenz ist, sodaß sich beim Ziehen, also bei einer Veränderung der Schwingfrequenz keine Veränderung der Kreisgüte ergibt.

Vorteilhafte Weiterbildungen des erfindungsgemäßen Oszillators sind in den Patentansprüchen 2 bis 7 ausführlich beschrieben.

Die Erfindung wird im folgenden anhand der Zeichnung näher erläutert.

In der Zeichnung zeigt

Fig. 1  die Prinzipschaltung eines erfindungsgemäßen, spannungsgesteuertenOszillators und

Fig. 2  ein detailliertes Schaltbild des Oszillators nach Fig. 1 .

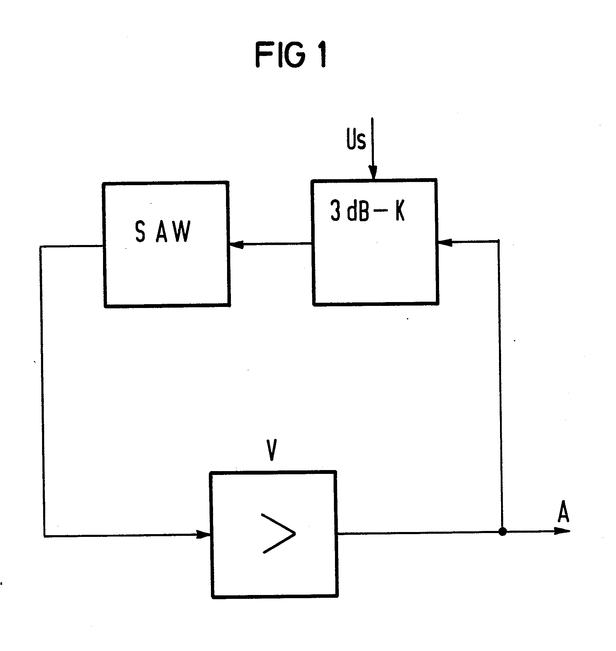

In der Fig. 1 ist der erfindungsgemäße spannungsgesteuerte Oszillator dargestellt, der einen Verstärker V mit einem Ausgang A für das erzeugte Signal enthält, wobei im Rückkopplungsweg des Verstärkers die Reihenschaltung einer Oberflächenwellenleitung SAW und eines 3dB-90° Kopplers mit einer zusätzlichen Steuerschaltung enthalten ist. Die Reihenfolge der Oberflächenwellenleitung und des 3dB-Kopplers ist beliebig, der 3dB-Koppler wird in der Literatur auch als 3dB-Hybridschaltung, 90°-Koppler, 90°-Hybridschaltung, 3dB-90° Koppler oder 4-Port-Hybridtransformer bezeichnet. Im Ausführungsbeispiel ist der Oszillator zur Erzeugung einer Schwingung mit einer Frequenz von etwa 167 MHz vorgesehen, die Oberflächenwellenleitung und der 3dB-Koppler sind für diesen Frequenzbereich ausgelegt. Im Hinblick auf die Spannungssteuerung enthält der 3dB-Koppler neben einem Anschluß Us für eine Steuerspannung mit dem Anschluß verbundene Kapazitätsdioden.

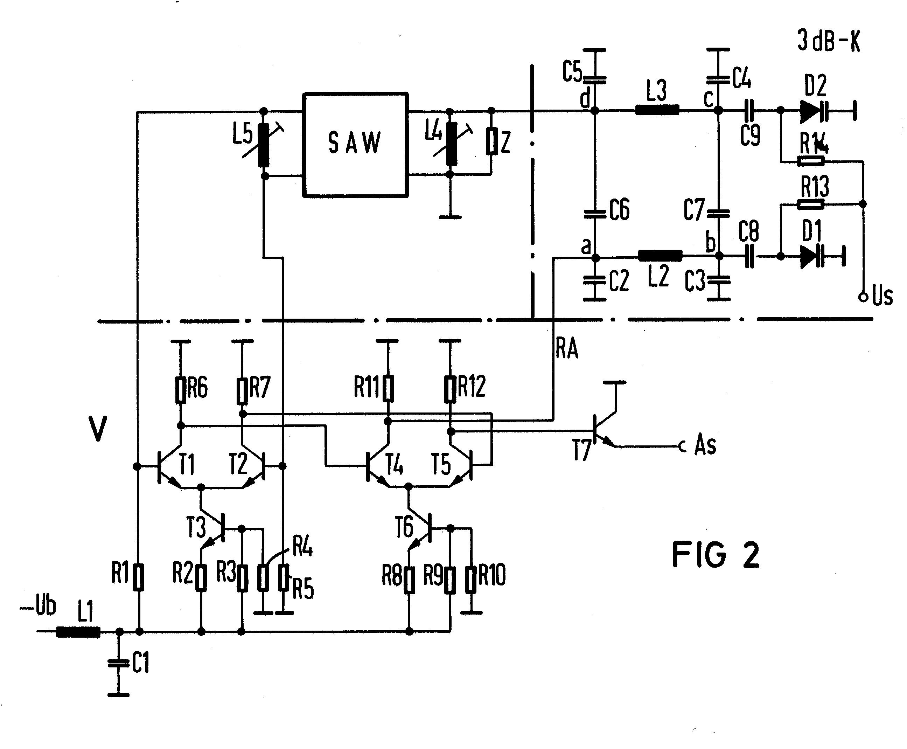

In der Fig. 2 ist der spannungsgesteuerte Oszillator nach der Fig. 1 genauer dargestellt. Als Verstärker V wurde die Reihenschaltung zweier emittergekoppelter Differenzverstärker vorgesehen, die im Gegentakt betrieben werden und die in vorteilhafter Weise im Schaltbetrieb das gewünschte rechteckförmige Ausgangssignal aufgrund einer verstärkerinternen Amplitudenbegrenzung erzeugen.

Der eingangsseitige emittergekoppelte Differenzverstärker enthält einen ersten und einen zweiten Transistor T1, T2, deren Emitteranschlüsse miteinander und mit dem Kollektoranschluß eines dritten Transistors T3 verbunden sind. Die Basisanschlüsse des ersten und des zweiten Transistors sind mit Ausgangsanschlüssen der Oberflächenwellenleitung SAW verbunden, der Basisanschluß des ersten Transistors ist außerdem über einen ersten Widerstand und über ein Siebglied aus einer ersten Induktivität L1 und einer ersten Kapazität C1 mit einer Betriebsspannungsquelle -Ub verbunden. Der Basisanschluß des zweiten Transistors T2 ist über einen fünften Widerstand R5 mit Bezugspotential verbunden, durch die ohmsche Verbindung an der Oberflächenwellenleitung SAW ergibt sich eine gleichstrommäßige Verbindung der Basisanschlüsse des ersten und des zweiten Transistors T1, T2 und damit ein Basisspannungsteiler aus dem ersten und dem fünften Widerstand R1, R5. Der dritte Transistor T3 ist mit seinem Emitteranschluß über einen zweiten Widerstand R2 und mit seinem Basisanschluß über einen dritten Widerstand R3 an das Siebglied für die Betriebsspannung angeschlossen. Aus dem dritten Widerstand R3 und einem vierten Widerstand R4, der mit dem Basisanschluß des dritten Transistors T3 einerseits und mit Bezugspotential andererseits verbunden ist, ergibt sich ein weiterer Basisspannungsteiler. Der Kollektoranschluß des ersten Transistors T1 ist über einen sechsten Widerstand R6 mit Bezugspotential und außerdem mit dem Basisanschluß eines vierten Transistors T4 verbunden, der Kollektoranschluß des zweiten Transistors T2 ist analog über einen siebten Widerstand R7 mit Bezugspotential und außerdem direkt mit dem Basisanschluß eines fünften Transistors T5 verbunden.

Die Emitteranschlüsse des vierten und des fünften Transistors T4, T5 sind zur Bildung eines zweiten emittergekoppelten Differenzverstärkers miteinander und mit dem Kollektoranschluß eines sechsten Kollektors T6 als Emitterstromquelle verbunden, dessen Emitteranschluß über einen achten Widerstand R8 und dessen Basisanschluß über einen

0119462

neunten Widerstand R9 mit dem Siebglied für die Betriebsspannung -Ub verbunden sind, der Basisanschluß des sechsten Transistors T6 ist außerdem über einen zehnten Widerstand R10 an Bezugspotential angeschlossen. Der Kollektor des vierten Transistors T4 ist über einen elften Widerstand R11 mit Bezugspotential verbunden und stellt außerdem den einen Ausgang RA des Verstärkers dar, der Kollektoranschluß des fünften Transistors T5 ist über einen zwölften Widerstand R12 an Bezugspotential angeschlossen und außerdem mit dem Basisanschluß eines siebten Transistors T7 verbunden, dessen Kollektor an Bezugspotential angeschlossen ist und dessen Emitter einen weiteren Ausgang des Verstärkers und gleichzeitig den Ausgang As des spannungsgesteuerten Oszillators darstellt.

Mit dem Ausgang RA des Verstärkers ist der Eingangsanschluß a des 3dB-Kopplers verbunden, der über einen zweiten Kondensator C2 mit Bezugspotential und über eine zweite Induktivität L2 mit einem zweiten Anschluß b des 3dB-Kopplers verbunden ist. Der zweite Anschluß b ist über einen dritten Kondensator C3 an Bezugspotential angeschlossen. Der Eingangsanschluß a des 3dB-Kopplers ist über einen sechsten Kondensator C6 mit dem Ausgangsanschluß d verbunden, der zweite Anschluß b ist über einen siebten Kondensator C7 mit dem dritten Anschluß c des 3dB-Kopplers verbunden, der seinerseits über einen vierten Kondensator mit Bezugspotential und über eine dritte Induktivität L3 mit dem vierten Anschluß, dem Ausgangsanschluß d, verbunden ist. Der Ausgangsanschluß d ist über einen fünften Kondensator mit Bezugspotential und außerdem mit einem Eingang der Oberflächenwellen-leitung SAW verbunden. Der zweite Anschluß b des 3dB-Kopplers ist über einen ersten Koppelkondensator C8 mit dem Anodenanschluß einer ersten Kapazitätsdiode D1 mit hyperabrupter Kennlinie und über einen dreizehnten Widerstand R13 mit einer Quelle Us für eine Steuerspannung verbunden. Der dritte Anschluß c des 3dB-Kopplers ist in analoger Weise über einen zweiten Koppelkondensator C9 mit dem Anodenanschluß einer zweiten Kapazitätsdiode T2 mit hyperabrupter Kennlinie und über einen vierzehnten Widerstand R14 mit der Quelle Us für die Steuerspannung verbunden. Die Katodenanschlüsse der Kapazitätsdioden sind mit Bezugspotential verbunden.

Die Kapazitätswerte des zweiten bis fünften Kondensators C2, C3, C4, C5, sind untereinander gleich, gleich sind auch die Kapazitätswerte des sechsten und des siebten Kondensators und die Induktivitätswerte der zweiten und der dritten Induktivität L2, L3. Damit handelt es sich zunächst um einen vollständig symmetrischen 3dB-Koppler an dem aber über die Koppelkondensatoren C8, C9 ein zusätzlicher Steuerteil angeschlossen ist. Beim wellenwiderstandsrichtigen Abschluß der Eingangs- und der Ausgangsseite und des zweiten und des dritten Anschlusses b, c des 3dB-Kopplers würde sich zwischen Eingangsanschluß a und Ausgangsanschluß b eine Phasenverschiebung von 90 Grad bei einer Dämpfung von 3dB, zwischen Eingangsanschluß a und Ausgangsanschluß b eine Phasenverschiebung von $0^o$ bei einer Dämpfung von 3dB und zwischen Eingangsanschluß a und Ausgangsanschluß d eine große Dämpfung ($\approx$ 20 dB Entkopplungsdämpfung) einstellen. Durch die Koppelkondensatoren C8 und C9 sind nun der zweite und der dritte Anschluß des 3dB-Kopplers mit einem zusätzlichen Netzwerk verbunden, dessen Impedanz über eine von außen angelegte Steuerspannung veränderbar ist, sodaß am zweiten und am dritten Anschlußpunkt des 3dB-Kopplers kein wellenwiderstandrichtiger Abschluß vorliegt und damit über eine veränderte Reflexion des Eingangssignals ein Signal erscheint, dessen Amplitude unabhängig von der Steuerspannung ist, dessen Phase sich jedoch mit der Steuerspannung verändert. Die Einfügungsdämpfung zwischen Eingang a und Ausgang b wird dann durch die Verluste der Reaktanzen bestimmt und beträgt bei der realisierten Schaltung ca. 1 dB.

0119462

Mit dem Ausgangsanschluß d des 3dB-Kopplers ist der eine Eingang einer für die Oszillatorschwingfrequenz von 167 MHz vorgesehene Oberflächenwellenleitung SAW verbunden, deren anderer Eingangsanschluß an Bezugspotential liegt und bei der erster und zweiter Eingangsanschluß über einen Widerstand Z mit einem Widerstandswert entsprechend dem Wellenwiderstand von etwa 75 Ohm und über eine erste Abgleichinduktivität L4 verbunden sind. Ebenso sind die beiden Ausgangsanschlüsse der Oberflächenwellenleitung über eine zweite Abgleichinduktivität L5 miteinander verbunden. Die Notwendigkeit dieser Abgleichinduktivitäten ergibt sich aus dem stark kapazitiven Eingangs- bzw. Ausgangswiderstand der Oberflächenwellenleitung. Die Ausgangsanschlüsse der Oberflächenwellenleitung, an denen das Ausgangssignal im Gegentakt ansteht, sind mit den Basisanschlüssen des ersten und des zweiten Transistors T1, T2 des Verstärkers V verbunden. Durch den gewählten Aufbau sind sowohl Verstärker als auch 3dB-Koppler wellenwiderstandsrichtig abgeschlossen. Aufgrund des gewählten Aufbaues ist der Verstärker leicht in integrierter Bauweise zu realisieren, in Verbindung mit dem als Emitterfolger geschaltetem Transistor T7 wird ein ECL-kompatibles Ausgangssignal erzeugt, der Ausgangsanschluß As kann aber auch unter Weglassung des Emitterfolgers direkt mit dem Kollektoranschluß des fünften Transistors T5 verbunden werden. Der Aufbau des 3dB-Kopplers erfolgte mittels konzentrierter Elemente, ein Aufbau in Stripline-Technik ist insbesondere bei der Verwendung bei höheren Frequenzen leicht möglich. Die im Steuerteil des 3dB-Kopplers verwendeten Kapazitätsdioden weisen eine sogenannte hyperabrupte Kapazitätskennlinie, also eine Kapazitätslinie mit steilem Anfangsbereich, auf und sind unter der Bezeichnung BB609 handelsüblich.

7 Patentansprüche

2 Figuren

0119462

## Patentansprüche

1. Spannungsgesteuerter Oszillator mit einem Verstärker und einem steuerbare Kapazitätsdioden enthaltenden Rückkopplungsnetzwerk, d a d u r c h g e k e n n z e i c h - n e t , daß das Rückkopplungsnetzwerk die Reihenschaltung einer Oberflächenwellenleitung (SAW) mit einem Durchlaßbereich entsprechend der vorgesehenen Oszillatorfrequenz und eines 3dB-90°-Kopplers mit zusätzlichem Steuerteil enthält und daß die beiden steuerbaren Kapazitäts dioden (D1, D2) über Koppelkondensatoren (C8, C9) mit denjenigen beiden Anschlüssen (b, c) des 3dB-90°-Kopplers verbunden sind, die nicht als Eingangs- oder Ausgangsanschluß dienen.

2. Spannungsgesteuerter Oszillator nach Patentanspruch 1, d a d u r c h g e k e n n z e i c h n e t , daß mit einem Ausgang (RA) des Verstärkers (V) der Eingangsanschluß (a) des 3dB-90°-Kopplers verbunden ist, dessen Ausgangsanschluß (d) mit einem Eingang der Oberflächenwellenleitung (SA) verbunden ist, und daß der Ausgang der Oberflächenwellenleitung mit einem Verstärkereingang verbunden ist.

3. Spannungsgesteuerter Oszillator nach Patentansprüchen 1 oder 2, d a d u r c h g e k e n n z e i c h n e t , daß die Anodenanschlüsse der Kapazitätsdioden (D1, D2) im Steuerteil des 3dB-Kopplers jeweils getrennt über einen Koppelkondensator (C8, C9) mit den freien Anschlüssen des 3-dB-Kopplers und über einen Entkopplungswiderstand (R13, R14) mit einer Quelle (Us) für eine Steuerspannung verbunden sind und daß die Katodenanschlüsse der Kapazitätsdioden an Bezugspotential angeschlossen sind.

4. Spannungsgesteuerter Oszillator nach Patentansprüchen 1 oder 3, d a d u r c h g e k e n n z e i c h n e t , daß

die Kapazitätsdioden eine hyperabrupte Kennlinie aufweisen.

5. Spannungsgesteuerter Oszillator nach Patentansprüchen 1 und 2, d a d u r c h  g e k e n n z e i c h n e t , daß die Oberflächenwellenleitung (SAW) zwei Eingänge aufweist, von denen der eine mit dem Ausgangsanschluß (d) des 3dB-90°-Kopplers und der andere mit Bezugspotential verbunden ist und daß beide Eingangsanschlüsse über eine Parallelschaltung verbunden sind, die einen ohmschen Widerstand (Z) mit einem etwa dem Wellenwiderstand entsprechenden Wert und eine erste Abgleichinduktivität (L4) enthält und daß die Oberflächenwellenleitung (SAW) zwei Ausgangsanschlüsse aufweist, die durch eine weitere Abgleichinduktivität (L5) verbunden sind.

6. Spannungsgesteuerter Oszillator nach Patentansprüchen 1 oder 2, d a d u r c h  g e k e n n z e i c h n e t , daß der Verstärker (V) die Reihenschaltung zweier emittergekoppelter Differenzverstärker enthält, die im Gegentakt betrieben werden, in dem die Stufeneingänge des ersten ermittergekoppelten Differenzverstärkers (T1, T2) jeweils getrennt mit den Ausgängen der Oberflächenwellenleitung (SAW) verbunden sind und daß die Stufeneingänge des zweiten emittergekoppelten Differenzverstärkers (T4, T5) jeweils getrennt mit den Stufenausgängen des ersten emittergekoppelten Differenzverstärkers verbunden sind.

7. Spannungsgesteuerter Oszillator nach Patentanspruch 6, d a d u r c h  g e k e n n z e i c h n e t , daß mit einem der Stufenausgänge des zweiten Differenzverstärkers (T4, T5) ein Emitterfolger (T7) verbunden ist, dessen Emitteranschluß den Ausgangsanschluß (As) des spannungsgesteuerten Oszillators darstellt.

## FIG 1

0119462

3dB-K

FIG 2

SAW

Us

As

V

-Ub

Components: D1, D2, D3, R13, R14, C2, C3, C4, C5, C6, C7, C8, C9, L1, L2, L3, L4, L5, Z, a, b, c, d, RA, R1, R2, R3, R4, R5, R6, R7, R8, R9, R10, R11, R12, C1, T1, T2, T3, T4, T5, T6, T7